Europäisches Patentamt

European Patent Office

Office européen des brevets

(11) Numéro de publication: **0 406 055 A1**

## DEMANDE DE BREVET EUROPEEN

(21) Numéro de dépôt: 90401685.4

(22) Date de dépôt: 15.06.90

(51) Int. Cl.5: **H05K 5/00**

(30) Priorité: 19.06.89 FR 8908128

(43) Date de publication de la demande:
02.01.91 Bulletin 91/01

(84) Etats contractants désignés:
CH DE GB LI

(71) Demandeur: EGIDE S.A.
Z.A. Pissaloup
F-78190 Trappes(FR)

(72) Inventeur: Maquaire, Jean-Pierre
Les Sources, 10, rue du Général Leclerc
F-78430 Louveciennes(FR)
Inventeur: Dody, Jean-Noel
10 rue C. Vapereau
F-92500 Rueil Malmaison(FR)

(74) Mandataire: Thibon-Littaye, Annick
Cabinet A. THIBON-LITTAYE 11 rue de
l'Etang
F-78160 Marly-le-Roi(FR)

(54) Procédé de fabrication d'un boîtier pour composants électroniques, notamment hybrides, et boîtier obtenu selon ce procédé.

(57) Procédé de fabrication d'un boîtier pour composants électroniques, notamment hybrides, comprenant un fond (1) et au moins trois parois latérales, caractérisé en ce qu'il comporte au moins une étape de découpe d'une plaque de tôle suivant des contours projetés à plat du fond (1) et des parois (2, 3, 4, 5), de manière à obtenir une embase constituée d'un fond et de flancs à rabattre propres à constituer des portions de tôle représentant les parois et une étape de brasure des extrémités latérales des parois les unes contre les autres.

Fig. 1A

## PROCEDE DE FABRICATION D'UN BOITIER POUR COMPOSANTS ELECTRONIQUES, NOTAMMENT HYBRIDES, ET BOITIER OBTENU SELON CE PROCEDE

La présente invention concerne un procédé de fabrication d'un boîtier pour composants électroniques, notamment hybrides, comprenant un fond et au moins trois parois latérales.

On connaît actuellement deux types de fabrication pour de tels boîtiers. Un premier procédé de fabrication consiste à rapporter par brasage sur une enceinte constituant les parois latérales un fond, de manière à obtenir une cuvette. Une deuxième solution consiste à obtenir la cuvette constituant le boîtier par emboutissage d'une plaque de tôle, afin de conformer d'une seule pièce le fond et les parois latérales du boîtier.

On utilise généralement comme matériau pour constituer l'enceinte et le fond du boîtier un alliage de fer, nickel, cobalt connu sous la dénomination commerciale "KOVAR" (marque déposée), en raison de son faible coefficient de dilatation thermique assurant au boîtier une bonne tenue mécanique.

De tels procédés de fabrication conviennent pour des fabrications en grande série de boîtiers, mais ne sont pas adaptés pour des fabrications en petite série, voire même à l'unité. En effet, ils nécessitent un outillage particulier pour chaque taille de boîtier, ce qui augmente considérablement le coût, lorsqu'on désire réaliser une petite série, voire même un seul boîtier comme prototype.

La présente invention vise à proposer un procédé de fabrication pour de tels boîtiers, sans qu'il soit nécessaire de recourir à un outillage adapté à chaque type et/ou taille de boîtier sans pour autant nuire à l'herméticité du boîtier une fois réalisé.

Selon sa caractéristique principale, la présente invention concerne un procédé de fabrication d'un boîtier pour composants électroniques, notamment hybrides, comprenant un fond et au moins trois parois latérales, caractérisé en ce qu'il comporte au moins une étape de découpe d'une plaque de tôle suivant des contours projetés à plat du fond et des parois, de manière à obtenir une embase constituée d'un fond et de flancs à rabattre perpendiculairement au fond ; des portions de tôle représentant les flancs à rabattre propres à constituer les parois, et une étape de brasure des extrémités latérales des parois les unes contre les autres.

Au moyen d'un tel procédé, il est désormais possible de réaliser à faible coût des boîtiers pour composants hybrides en faible série, voire même de réaliser un seul exemplaire d'un type de boîtier particulier sans pour autant qu'il soit nécessaire d'avoir recours à un outillage particulier pour chaque type de boîtier.

De plus, on peut ainsi réaliser un boîtier plié sans qu'il ne soit nécessaire que l'épaisseur de la tôle soit suffisante pour absorber un usinage en biais à chaque pliure.

Le procédé selon l'invention comporte avantageusement une étape de perçage de trous destinés au passage de connecteurs de liaison avec l'extérieur du boîtier.

En effet, dans de tels boîtiers, les liaisons entre les composants hybrides, contenus dans le boîtier et les circuits électroniques disposés à l'extérieur de celui-ci sont généralement constitués de connecteurs en cuivre, entourés d'une perle de verre ou de céramique traversant une paroi ou le fond du boîtier. On réalise pour cela des trous destinés à recevoir les perles de verre au centre desquelles sont placées les tiges de cuivre constituant les connecteurs.

Ladite étape de perçage est selon l'invention avantageusement mise en oeuvre postérieurement à l'étape de pliage des parois du boîtier, afin d'éviter que les trous ne soient déformés en raison des déplacements de matières intervenant sur les zones de pliage lors de cette étape.

Afin de faciliter le pliage des flancs à rabattre en vue de constituer les parois, ladite embase est avantageusement découpée de sorte que chacun des flancs à rabattre présente sur ses deux coins en regard du fond, un dégagement de matière.

De tels dégagements de matières sont avantageusement ponctuels dans la direction de la ligne de pliage. Par exemple, la longueur d'un dégagement n'excédant pas 1/5ème de la longueur de la paroi.

Selon une caractéristique particulièrement avantageuse du procédé selon l'invention, ladite embase est découpée de sorte que au moins certains de ses flancs à rabattre se prolongent à au moins une de leurs extrémités, au-delà de l'extrémité du fond correspondant, ledit prolongement ayant de préférence une longueur équivalente à l'épaisseur de la plaque de tôle, et le nombre total de prolongements réalisés étant de préférence égal au nombre de flancs.

De tels prolongements des flancs à rabattre permettent d'assurer une bonne herméticité des coins du boîtier une fois réalisé, chacun des prolongements, une fois le flanc correspondant plié, prenant appui sur la tranche du flanc avec lequel il coopère pour constituer un coin du boîtier.

On peut prévoir de réaliser un prolongement sur une extrémité de chacun des flancs de l'embase, deux prolongements ne devant alors pas être en regard l'un de l'autre. On peut également prévoir, par exemple dans le cas d'un boîtier carré ou rectangulaire, dont l'embase comporte quatre flancs, que deux flancs opposés comportent chacun un prolongement à chacune de leurs extrémités, et que les autres flancs ne comportent aucun prolongement.

Toute autre disposition des prolongements peut bien sûr être envisagée, il est néanmoins préférable de prévoir de disposer d'un seul prolongement à chaque coin du boîtier, et donc que le nombre total des prolongements réalisés soit égal au nombre de flancs.

Une fois que les flancs ont été rabattus perpendiculairement au fond lors de l'étape de pliage, les coins du boîtier sont brasés aux endroits où les flancs se rejoignent, afin d'assurer à la cuvette de boîtier ainsi constituée une bonne herméticité.

Au moyen d'un tel procédé, il est désormais possible de réaliser des boîtiers en petite série suivant les demandes particulières des utilisateurs, et ce sous différentes formes. On peut en effet envisager de réaliser des boîtiers dont les parois forment entre elles un triangle, un carré ou un rectangle, ou encore n'importe quel polygone, et ce sans avoir recours à un outillage spécifique pour chaque forme de réalisation.

L'étape de découpe de la plaque de tôle peut être réalisée par n'importe quel moyen connu, mais on veillera à utiliser de préférence des moyens de découpe permettant une bonne précision. Cette étape peut donc être réalisée, par exemple par emboutissage ou par grignotage de la plaque de tôle, ou encore au moyen d'un laser ou d'un jet d'eau sous pression.

Une fois la préparation de la cuvette terminée, les connecteurs et perles de verre sont mis en place de manière usuelle. Le boîtier comporte également un couvercle destiné à être soudé sur les parois latérales du boîtier postérieurement à la mise en place des composants hybrides dans la cuvette.

La plaque de tôle utilisée pour la fabrication du boîtier, ainsi que le couvercle, sont de préférence en KOVAR (marque déposée).

On décrira maintenant plus en détail une forme de réalisation particulière de l'invention qui en fera mieux comprendre les caractéristiques essentielles et les avantages, étant entendu toutefois que cette forme de réalisation est choisie à titre d'exemple et qu'elle n'est nullement limitative. Sa description est illustrée par les dessins annexés, dans lesquels :

- les figures 1A et 1B représentent respectivement, en vue de dessus et de côté, une embase de boîtier obtenue au moyen du procédé selon l'invention avant que les flancs ne soient repliés ;

- les figures 2A, 2B et 2C représentent respectivement, en vue de dessus (figure 2A) et de côté (figures 2B et 2C), l'embase représentée aux figures 1A et 1B, une fois le procédé selon l'invention achevé.

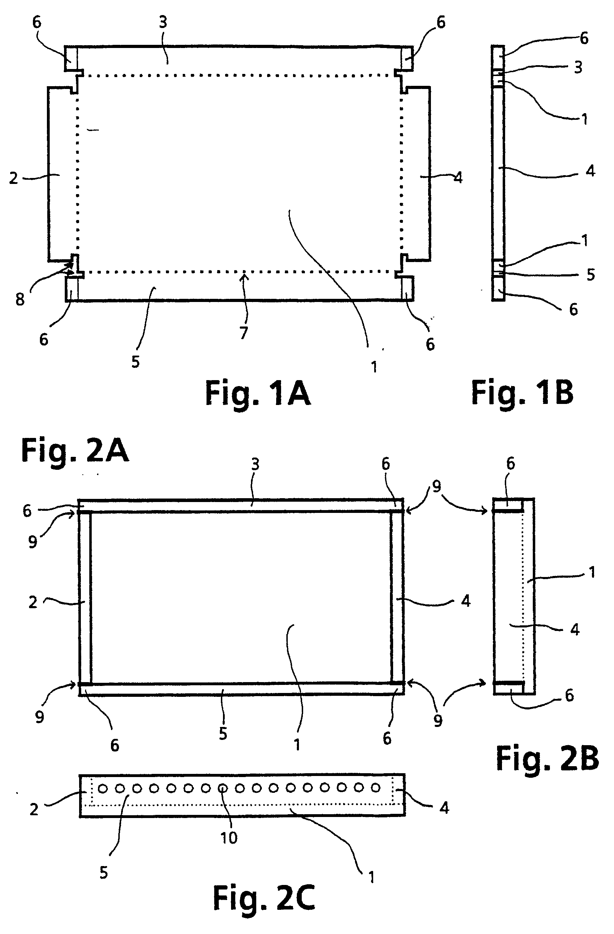

L'embase représentée à la figure 1 avant son pliage est destinée à la fabrication d'un boîtier rectangulaire.

Cette embase est constituée d'une plaque de KOVAR dont l'épaisseur est choisie en fonction de l'épaisseur désirée pour les parois et le fond du boîtier. Elle comporte une portion de tôle constituant un fond 1 et quatre portions 2, 3, 4 et 5 représentant les flancs à rabattre propres à constituer les parois du boîtier. Etant donné que le boîtier que l'on veut obtenir est rectangulaire, les flancs 2 et 4 constitueront les parois transversales et les flancs 3 et 5 les parois longitudinales.

Les flancs 3 et 5 comportent à chacune de leurs extrémités latérales un prolongement 6 de longueur identique à l'épaisseur de la tôle constituant les flancs 2 et 4. La longueur totale de chacun des flancs 3 et 5 se trouve donc être égale à la longueur du fond 1 plus deux fois l'épaisseur de la portion de tôle constituant les flancs 2 et 4.

Les flancs 2 et 4 sont quant à eux raccourcis à chacune de leurs extrémités par rapport à la longueur du petit côté du fond 1 d'une épaisseur équivalente à l'épaisseur des flancs 3 et 5. Leur longueur totale est donc égale à la largeur du fond 1 moins deux fois l'épaisseur de la portion de tôle constituant les flancs 3 et 5.

Afin de faciliter le pliage des flancs du boîtier, ceux-ci comportent sur les deux coins qui sont en regard du fond 1, c'est-à-dire en regard d'une zone de pliage 7 constituée par l'intersection entre les flancs et le fond, un dégagement 8 sur une faible surface.

Les figures 2A, 2B et 2C représentent le boîtier obtenu à partir de l'embase représentée 1A et 1B.

On y retrouve le fond 1, ainsi que les flancs constituant désormais les parois latérales 2, 3, 4 et 5. Une fois que les flancs se trouvent rabattus perpendiculairement au fond, tel que représenté à la figure 2A, ces derniers sont brasés 9 (figure 2B en vue de côté transversale) à leur point de contact entre flancs voisins, de manière à assurer l'étanchéité du boîtier ainsi constitué.

La figure 2C représente le boîtier en vue de côté longitudinale, on y distingue la paroi latérale 3 dans laquelle ont été ménagés des trous 10 de passage de connecteurs électriques entre l'intérieur et l'extérieur du boîtier. Ces connecteurs sont habituellement entourés d'une perle de verre qui est elle-même insérée dans les trous 10.

Les trous peuvent être ménagés sur n'importe quelle face du boîtier, et même selon les besoins, sur le fond.

Naturellement, l'invention n'est en rien limitée par les particularités qui ont été spécifiées dans ce qui précède ou par les détails du mode de réalisation particulier choisi pour illustrer l'invention. Toutes sortes de variantes peuvent être apportées à la réalisation particulière qui a été décrite à titre d'exemple et à ses éléments constitutifs sans sortir pour autant du cadre de l'invention. Cette dernière englobe ainsi tous les moyens constituant des équivalents techniques des moyens décrits ainsi que leurs combinaisons.

**Revendications**

1. Procédé de fabrication d'un boîtier pour composants électroniques, notamment hybrides, comprenant un fond (1) et au moins trois parois latérales, caractérisé en ce qu'il comporte au moins une étape de découpe d'une plaque de tôle suivant des contours projetés à plat du fond (1) et des parois (2, 3, 4, 5), de manière à obtenir une embase constituée d'un fond et de flancs à rabattre propres à constituer des portions de tôle représentant les parois et une étape de brasure des extrémités latérales des parois les unes contre les autres.

2. Procédé selon la revendication 1 caractérisé en ce qu'il comporte une étape de perçage de trous (10) destinés au passage de connecteurs de liaison avec l'extérieur du boîtier, ladite étape de perçage étant de préférence mise en oeuvre postérieurement à l'étape de pliage.

3. Procédé selon la revendication 1 ou 2 caractérisé en ce que lors de l'étape de découpe ladite embase est découpée de sorte que au moins certains des flancs à rabattre (3, 5) se prolongent à au moins une de leurs extrémités latérales, au-delà de l'extrémité du fond correspondante, ledit prolongement (6) ayant de préférence une longueur équivalente à l'épaisseur de la plaque de tôle et en ce que un flanc (2, 4) dont une extrémité se trouve en regard d'un prolongement (6) est raccourci sur cette extrémité d'une longueur équivalente à l'épaisseur de la plaque de tôle.

4. Procédé selon l'une quelconque des revendications 1 à 3 caractérisé en ce que lors de l'étape de découpe, ladite embase est découpée de sorte que chacun des flancs à rabattre présente sur ses deux coins en regard du fond un dégagement de matière (8) destiné à faciliter le pliage ultérieur des flancs, ledit dégagement étant de préférence ponctuel et dans la direction de la ligne de pliage.

5. Procédé selon l'une quelconque des revendications 1 à 4 caractérisé en ce que ladite étape de découpe est réalisée par emboutissage de la plaque de tôle.

6. Procédé selon l'une quelconque des revendications 1 à 4 caractérisé en ce que ladite étape de découpe est réalisée par grignotage de la plaque de tôle.

7. Procédé selon l'une quelconque des revendications 1 à 4 caractérisé en ce que ladite étape de découpe est réalisée au moyen d'un laser ou au moyen d'un jet d'eau sous pression.

8. Boîtier pour composants hybrides caractérisé en ce qu'il a été obtenu par la mise en oeuvre du procédé selon l'une quelconque des revendications 1 à 7.

**Fig. 1A**

**Fig. 1B**

**Fig. 2A**

**Fig. 2B**

**Fig. 2C**

Office européen des brevets

# RAPPORT DE RECHERCHE EUROPEENNE

Numero de la demande

EP    90 40 1685

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | DE-A-3438702 (LICENTIA PATENT VERWALTUNGS GMBH) * page 3, lignes 12 - 18; figure 3 * | 1 | H05K5/00 |
| Y | * revendication 1 * | 2 | |
| Y | EP-A-233824 (ISOTRONICS INC.) * colonne 2, lignes 32 - 47; figure 3 * | 2 | |

DOMAINES TECHNIQUES
RECHERCHES (Int. Cl.5)

H05K
B65D

Le présent rapport a été établi pour toutes les revendications

| Lieu de la recherche | Date d'achèvement de la recherche | Examinateur |
|---|---|---|
| BERLIN | 24 SEPTEMBRE 1990 | CLOSA, D |

EPO FORM 1503 03.82 (P0402)